# EUROPEAN PATENT SPECIFICATION

(11) **EP 2 287 883 B1**
(45) Date of publication and mention of the grant of the patent: **16.08.2017**
(21) Application number: 10011090.7
(22) Date of filing: 15.04.2004
(51) Int. Cl.: H01J 37/02, H01J 37/28

(54) **Apparatus and method for investigating or modifying a surface with a beam of charged particles**
Vorrichtung und Methode zur Untersuchung oder Modifizierung einer Oberfläche mittels Ladungsträgerstrahls
Dispositif et méthode d'inspection ou de modification d'une surface à l'aide d'un faisceau de particules chargées

(43) Date of publication of application: 23.02.2011
(62) Divisional of application: 04008972.4
(73) Proprietor: Carl Zeiss SMT GmbH, 73447 Oberkochen (DE)
(72) Inventor: Edinger, Klaus, 64653 Lorsch (DE); Sellmair, Josef, 85356 Freising (DE); Hofmann, Thorsten, 63110 Rodgau (DE)
(74) Representative: Wegner, Hans

(56) References cited:
- EP-A1- 0 884 759
- EP-A2- 1 505 438
- DE-A1- 3 545 350
- DE-A1- 10 208 043
- US-A- 4 992 661
- US-A- 5 591 971
- US-A- 5 789 748
- US-A1- 2001 002 697
- US-A1- 2002 148 960

## Description

### 1. Technical Field

The present invention relates to an apparatus and a method using one or more charged particle beams for the investigation and / or modification of a sample. In particular, the invention concerns the investigation and / or modification of sample surfaces by low voltage scanning particle beams, for example in a scanning electron microscope.

### 2. The prior art

In many microscopy techniques such as scanning electron or scanning ion microscopy, a focused beam of charged particles is scanned across the sample. The particles, which are emitted or scattered from the sample, are collected by a detector to provide a two-dimensional image. Scanned beams of particles, in particular electrons, are also used for modifying the surface, for example by selectively removing or depositing material onto a sample surface. Such a technique is for example described in the publication "Three-dimensional additive electron-beam lithography" in SPIE Vol. 2780, p. 388 of Koops et al.. The selective deposition or removal of material with a high resolution is of particular interest for the repair of masks used in the semiconductor industry.

It is common knowledge that charging effects can significantly impair the image quality of a scanning electron microscope, in particular when imaging electrically isolating features of a sample. The impinging beam of charged particles (primary beam) causes areas of the sample surface to charge to arbitrary voltages, depending on the properties and the polarity of the primary beam and on the amount and polarity of the secondary particles (forming the so called secondary beam), which are generated by the primary beam. The resulting charge distributes across the sample surface in a manner depending on its geometry and structure with its insulating and conductive regions as well as on electrical properties of areas surrounding the sample

The surface charges in turn lead to a deformation (e.g. defocusing, stigmation) and a deflection (e.g. image drift, image distortion) of the focused primary beam. The image drift is the most severe problem of high precision scanning electron microscopy for metrology applications such as CD-SEM (scanning electron microscopy for the measurement of critical dimensions), since it depends on the geometry of conductive or non-conductive features on the sample. This structure can vary from sample to sample, from field of view (FOV) to FOV, and from one set of sample material composition to another.

Furthermore, the amount of secondary electrons and their trajectories are affected by the surface charges. Since the amount of secondary electrons collected by a detector is used to determine the local brightness of the generated image, the contrast of the images is also affected by surface charging. In particular in cases where high positional accuracy is requested, such as the inspection of masks or wafers by scanning electron microscopy, charging effects limit the accuracy of the measurement of electrically isolated features. Especially low voltage electron microscopy is suffering from charge accumulation effects, since the primary and secondary beam are more susceptible to electrical fields in their respective paths compared to high voltage electron microscopy.

In order to overcome this problem, various approaches have been developed in the prior art to eliminate undesired charge accumulation or at least to reduce its effects:
One commonly used solution of the problem of charge accumulation on insulating objects is the application of a conductive layer on the sample surface. However, applying such a layer is not always possible and even excluded for several applications in the semiconductor industry. Another method is to additionally provide a further beam of charged particles to deliver opposite charges to the sample, for example using charge neutralizing electron flood guns in systems for FIB (Focused Ion Beam). A further method is to apply proper electric potentials near the sample surface to prevent secondary electrons from escaping the sample surface, thus inhibiting an excessive positive charge build-up. Yet another method is to vary scan conditions in order to vary charging conditions and to avoid excessive asymmetrical charging.

Some methods to overcome the problems related to accumulation of charges are described in more detail in following list of prior art patents and publications:
U S patent no. 4,818,872 discloses a system in which neutralizing electrons from a flood gun are directed by deflection elements below the final lens onto the sample. US patent no. 6,683,320 addresses the problem of focussing and positioning of a focussed ion beam onto an insulating sample. A neutralizing electron beam is disclosed, which is passed through the final lens for neutralization of at least a portion of the accumulated positive charge of the sample.

US patent no. 6,344,750 addresses the problem of asymmetrical charging, resulting in image distortions and image contrast variations in scanning electron microscope images. The solution disclosed in this patent consists of a two-fold scan procedure, one to charge the surrounding area of the image field and a second to scan the image field itself.

US patent no. 6,570,154 addresses the charging of different areas of an insulating sample by the primary electron beam of a scanning electron microscope. A solution is disclosed which multiplexes between two different scan conditions, one having the intention to acquire an image, the other to control charge build-up.

The US 4,992,661 discloses a method of neutralizing an accumulated charge on a surface of a specimen which is examined in a scanning electron microscope or a scanning ion microprobe mass analyzer. An electrically conductive thin film is deposited on a part of the specimen surface. The thin film covers at least a part of the specimen surface and may leave exposed areas of the underlying specimen.

The US 5,591,971 discloses an electrically conductive shielding mesh structure interposed between a scanning electron microscope and a sample being examined. This shield prevents electrical field leakage from the microscope from reaching the sample, where it would otherwise unpredictably interact with various sample compositions or structures, causing uncertainty in the working and focal distances.

The DE 35 45 350 A1 discloses a grounded grid or mesh electrode for an electron microscope to create directly above the sample an area free of a field. Secondary electrons passing the plane of a mesh are accelerated in the direction of a detector system but no longer pulled away from the sample. This reduces high positive charging.

The EP 0 884 749 A1 discloses a secondary ion mass spectrometer having an aperture mask. The aperture is preferably circular and has a diameter in the range of a few millimeters to a few centimeters.

The US 2002/0148960 A1 discloses a scanning electron microscope comprising a shield electrode arranged between an object lens and the sample. An aperture is arranged for passing the primary beam. A typical diameter of the aperture in the shield is 20 mm and the distance between the sample and the bottom face of the object lens is 3 mm.

The US 2001/002697 A1 discloses an inspection method and an apparatus where a grid is disposed between the objective lens of an electron microscope and an object to be investigated.

The European patent application EP 505 438 A2, published on 09-02-2005 and having priority of 24-07-2003, discloses a stencil mask which is capable of attaining long durability without any special processing thereon. An inversion means for inverting the front and back of the stencil mask formed with an opening pattern penetrating in the thickness direction is provided so that positions can be changed that is a surface irradiated with charged particles can be on the side of facing to the substrate subjected to processing, and the surface faced to the substrate can be on the side receiving irradiation of charged particles, and the inversion means comprises a mask holder for electrostatically sticking with an outer circumferential part of the stencil mask and a rotation means for rotating the mask holder about an axis of a supporting portion.

The stencil mask is arranged to face to the substrate by leaving a distance of, for example, several tens of µm to 100µm.

The DE 102 08 043 A1, finally, discloses a system for processing materials including an electron microscope. A pressure aperture is arranged above the sample, wherein this pressure aperture has a diameter of 200 µm.

US patent no. 6,586,736 addresses the problem of charging effects of insulating samples affecting secondary particle detection efficiency and darkening of the scan field during continuous scanning due to charge accumulation. A solution is presented using voltages applied to electrodes above the target in order to suppress excessive positive charge build-up and to generate a clear image. It is an active scheme acting on the trajectories of secondary particles emitted from the sample surface. A negative voltage is applied to the electrode such that at least some of the emitted particles (e.g., secondary electrons) from the surface are repelled away from the electrode back towards the surface to cancel positive charge that has accumulated on the surface. The applied voltage is being actively adjusted depending on the distance of the primary beam scan from the center of the electrode.

US patent no. 6,664,546 addresses the problem of optimizing image quality of a scanning electron microscope by measuring sample surface charge and calculating a set of SEM parameters for optimum operating conditions.

German Patent DE 44 12 415 A1 of Advantest Corp., referenced in US patents 6,664,546 and 6,586,736, discloses a method of using saddle point potentials to control excessive charge accumulation.

US patent no. 5 789 748 discloses an electron beam system which comprises a lens unit having a built-in semiconductor junction detector. The detector surrounds the sample-side of the focusing electrode just upstream from a retarding electrode which is positioned less than a millimeter from the sample. The retarding electrode may be attached by a 100 µm thick conductive spacer to the sample surface. The bore diameter of the retarding electrode is 100 µm.

All of these approaches are very complicated, either with respect to the necessary instrumentation, which has to be added to the overall apparatus and / or with respect to the process steps necessary to acquire an image. In addition, none of the prior art techniques is capable to fully remove the effects of surface charging on the resulting image.

It is therefore the problem underlying the present invention to provide an apparatus and a method, which allow in an easy and therefore cost-efficient manner to investigate and / or to modify a sample surface with charged particles, wherein the above explained problems related to surface charge accumulation are overcome.

### 3. Summary of the invention

According to a first aspect, the present invention relates to an apparatus for investigating and / or modifying a sample with charged particles, in particular a scanning electron microscope, comprising a beam of charged particles, a shielding element having an opening for the beam of charged particles to pass through, wherein the opening is sufficiently small and the shielding element sufficiently closely positioned to the surface of the sample to reduce the influence of charge accumulation effects at the surface on the beam of charged particles. The invention is defined in the independent claims 1 and 9. The opening has preferably a geometry, which allows a sufficient field of view (FOV), i.e. the primary and / or secondary beam paths remain substantially unobstructed in this area. In a preferred embodiment, the opening has a diameter d, wherein d ≤ 150 µm, preferably ≤ 100µm, more preferably ≤ 50µm and most preferably ≤ 10 µm.

Outside the FOV, the shielding element of the present invention shields the electric field caused by charges accumulating at the sample surface. To this end, the shielding element has preferably an outer dimension of ≤ 0.2 mm, preferably ≥ 2 mm, more preferably ≥ 5 mm and most preferably ≥ 10 mm. Without shielding, these charges would form an electric field penetrating the path of the primary beam and thus deflect its impact position as well as influence the emission properties of the secondary beam. Using the present invention, essentially all lines of the electric flux caused by the surface charges are terminated at the surface of the shielding element. The geometry of the opening in the shielding element and its distance to the sample can be chosen such that a reduction to an essentially zero charge accumulation effect is accomplished.

Since the basic principle of the present invention is to provide a passive shielding of electrical fields generated by charge built-up and not the active influencing of the trajectories of primary or secondary beams, the shielding element is grounded. In a first embodiment the opening of the shielding element has a substantially circular shape. According to the invention, the beam is scanned over the surface and the opening of the shielding element has a shape corresponding to the part of the surface, which is scanned, for example a substantially rectangular or hexagonal or triangular shape. In yet another embodiment the opening has a slit-like shape, wherein the slit has a width d, for which preferred values were indicated above. This embodiment is especially valuable in electron beam raster scan writing tools, which are employed in the semiconductor process industry.

In a particularly preferred embodiment of the present invention, the shielding element comprises a conductive grid, wherein the grid has preferably a mesh with more than 200 pitch per inch (78.74 per centimeter), preferably more or equal to 700 pitch per inch (275.59 per centimeter), and / or a transmissivity T of 30 % ≤ T ≤ 80 % and / or a thickness of 1 - 30 µm. Such a shielding element facilitates the (optical) orientation of the operator on the sample surface, which can be inspected through the (semi-) transparent grid.

In another embodiment the shielding element comprises a conductive membrane, wherein the opening in the membrane has preferably been produced by micro-machining methods such as electron beam lithography, focussed ion beam techniques (FIB), laser beam micro-machining or MEMS.

Further devices are preferably integrated into the shielding element, for example a distance sensor and / or one or more gas supplies. The latter are particularly advantageous, if the sample surface is not only to be observed but also to be modified, for example by electron beam induced chemical reactions.

Further advantageous modifications of the described apparatus form the subject matter of further dependent claims.

According to a further aspect, the present invention relates to a method for investigating and / or modifying a surface with an apparatus as described above. Preferably, the method is used for the repair of a mask, preferably by selective removal and / or deposition of material from or on the mask, respectively. In a further embodiment, the apparatus according to the present invention is used for CD-SEM in order to provide exact references for the investigation of masks and / or semiconductor products.

### 4. Short description of the drawings

In the following detailed description presently preferred embodiments are described with reference to the drawings, which show:
- Fig.1:: A schematic representation of the surface charges and their influence on the primary and secondary beam of charged particles without the present invention;
- Fig. 2:: a schematic representation of an embodiment of the present invention to illustrate the underlying physical principle;
- Fig. 3:: a schematic representation of the shielding effect for the surface charge in an embodiment of the present invention.
- Fig. 4:: a schematic representation of the relevant dimensions in an embodiment of the present invention;
- Fig. 5a - c:: three different embodiments for a shielding element; and
- Fig. 6a, 6b:: further embodiments of the present invention comprising a gas supply for electron-beam induced deposition of material.

### 5. Detailed Description of presently preferred embodiments

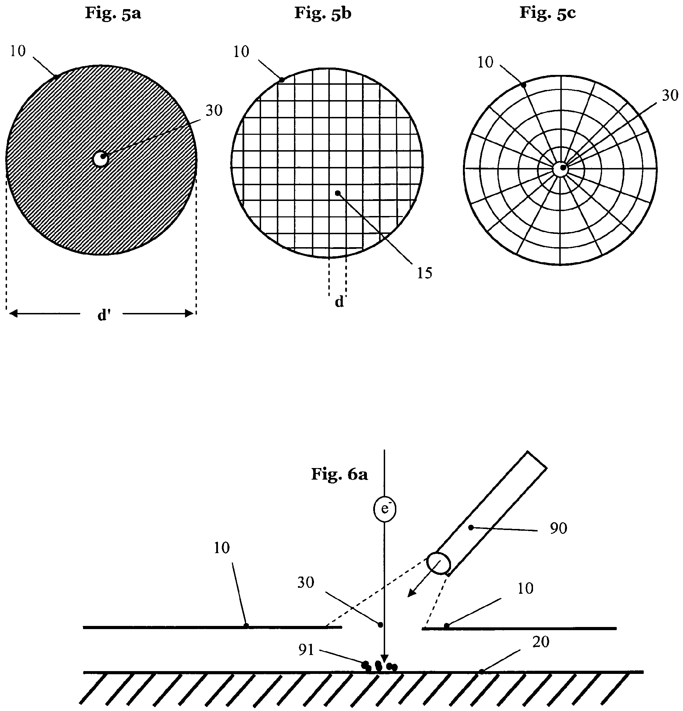

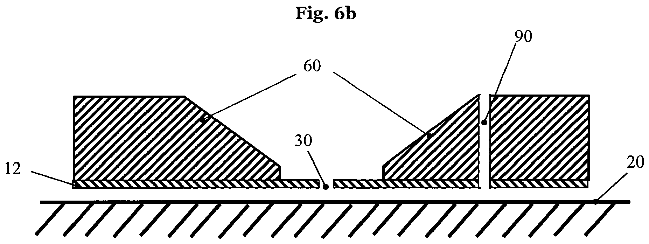

In the following, presently preferred embodiments of the invention are described with particular reference to a scanning electron microscope. However, it is to be understood that the present invention can be used for any apparatus, wherein electrically charged particles are used to study, image or modify a sample either on its surface or in its interior regions. A particular important field of use, which is further described below with reference to Figs. 6a and 6b, is the repair of masks for the semiconductor industry, Here, the scanned electron beam is used to selectively deposit or remove material from the surface of the mask.

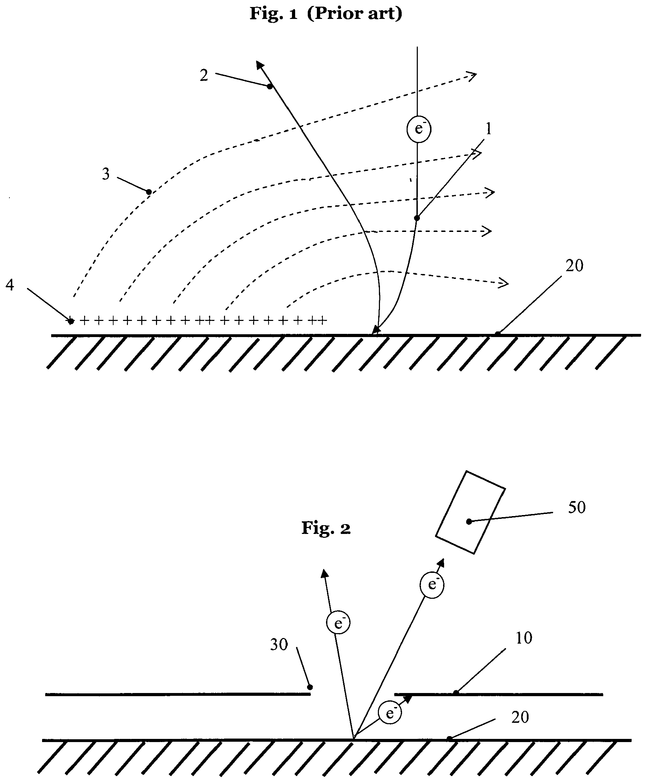

Fig. 1 illustrates the problem typically encountered in scanning electron microscopy, in particular with electrons of low energy: Charge distribution 4 is built up at the surface of a sample 20 by charge deposition of a primary beam 1 (negative charging), and by charged particle emission in a secondary beam 2 (positive charging). Fig. 1 shows an example of positive charging. Events of "higher order", such as secondary electrons landing on the sample surface 20 away from the primary beam landing point or secondary particles hitting a surface and releasing further particles do also contribute to the local and temporal charge distribution 4 on the sample surface 20. In addition, conducting or partially conducting features extending from the FOV to outside regions will lead to an inhomogeneous charge distribution 4.

The accumulated charge distribution 4 can be symmetric or asymmetric, the first influencing mainly focus properties of the primary beam 1 and brightness of image, the second influencing primary beam shape (e.g. stigmation) and primary beam deflection (e.g. image distortion and image drift). Fig. 1 illustrates in a substantially simplified manner the influence of the charge distribution 4 on the trajectories of the primary beam 1 and the secondary beam 2 due to the electric flux 3.

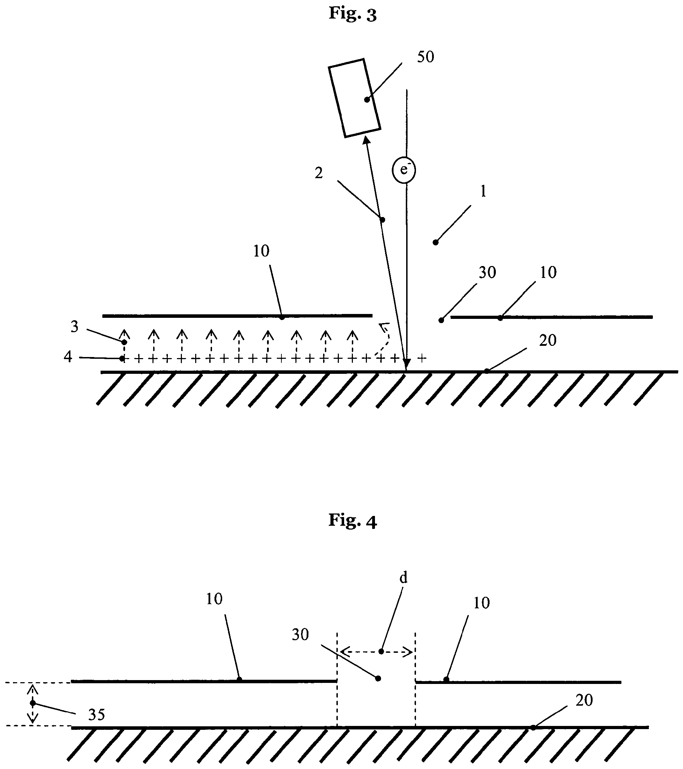

Figs. 2 - 4 illustrate schematically the principle of the present invention: The primary beam is passing through an aperture opening 30 of a shielding electrode 10. The dimensions of the aperture 30 are as small as possible without limiting the primary beam scan field. In addition, the shielding electrode 10 is positioned so close to the sample surface 20 that it effectively shields any electrical fields 3 which might exist or arise by sample surface charges 4 outside the aperture opening. This is shown in Fig. 3. For a better comparison with Fig. 1, surface charges 4 and the resulting lines 3 of the electric flux are for the sake of simplicity only shown for the region left of the impact point of the primary beam 1.

A part of the secondary particle beam 2 passes through the opening 30 of the shielding electrode 10 and reaches the detector 50. The detector signal in combination with the information of primary beam landing position is used to generate the image. Only surface charges 4 within a certain area around the center of the electrode opening 30 can contribute to primary beam shifting, leading to false information of the primary beam landing position, and therefore leading to a distortion of the generated image. The shielding electrode 10 is so closely arranged to the primary beam 1 landing position on the sample surface 20 that the secondary or higher order particles are prevented from reaching regions outside the aperture opening 30. However, to this end it is not necessary that the shielding electrode 10 is completely covering the region outside its opening 30. Preferably, the outer dimension d' of the shielding electrode (cf. Fig. 5a) is equal or greater than 0.2 mm, preferably more than 2 mm.

The remaining charges in a region inside the FOV, where the electrode 10 has no shielding effect can contribute to the charging effect. However, if this region is small enough, depending on uniformity and magnitude of remaining charge build up, the effect on the primary beam landing position or on the secondary beam properties such as energy or emission angle is small enough. As a result, there is only a negligible influence on the quality of the image recorded by the detector 50 of the scanning electron microscope.

The present invention discloses a solution, which is passive in its working principle, in contrast to many of the above discussed prior art approaches, such as disclosed in US patent no. 6,586,736. In other words, it is preferably independent of the specific scanning procedures, electrical conductance of the sample surface 20, or additional compensating particle beams. It does neither need varying voltages applied to the shielding electrode 10, nor does it need an electrode voltage other than zero, nor does it need more than one electrode 10. In the preferred embodiment, the shielding electrode 10 is kept at a fixed potential, which is achieved by grounding the electrode.

The apparatus according to the present invention can be used for the investigation and / or modification of any material, either conductive or insulating, any feature size, and any field of view as long as it is smaller than the free opening d of the aperture 30 (cf. Fig. 4). The latter is determined by the maximum tolerable influence length of asymmetrically surface charges and is typically below 100 microns. For applications with high accuracy, such as CD-SEM, smaller openings are preferred having a diameter d of less than 50 microns or even less than 10 microns.

The distance 35 of the aperture plane to the sample surface 20 is also typically below 100 microns. The other extreme is to contact the sample surface 20 with the shielding electrode 10, which is possible as well, although not desirable in most cases for sample integrity, and which is an aspect not being part of the claimed invention. Preferred values of the distance 35 are below 50 microns or even below 10 microns.

The physical principles of reducing charging effects employed by this invention are preferably: (a) the suppression of secondary particles (generated by the primary beam) landing on the sample in regions outside the interesting FOV, and (b) the shielding of electrical fields generated by accumulated charges in regions outside the interesting FOV. Due to the introduction of an aperture 30, electric fields generated by surface charges outside the FOV are essentially terminated at the aperture surface 10 and do not influence the trajectories of the primary or secondary beam above the aperture plane. The primary beam 1 and the secondary beam 2 might still be affected by (a) charges accumulated inside the aperture opening and (b) by electric fringe fields below the aperture plane. The first effect can be minimized by reducing the aperture opening 30, the latter by reducing the distance 35 between sample surface and aperture plane. Therefore, the present invention can suppress charge accumulation effects to any limit required by making the aperture opening 30 sufficiently small and positioning the shielding electrode 10 with its opening 30 sufficiently close to the sample surface 20.

The shielding electrode 10 comprises an easy to generate aperture 30, which is in one embodiment a circular opening (cf. Fig. 5a), which is located at a distance 35 of about 100 microns or less above the sample surface (cf. Fig. 4). The diameter d of this opening is small enough so that the remaining charging effects are small enough for the desired image quality and accuracy (e.g. d is in the order of a few hundred microns or less). This embodiment is usually sufficient for an image quality to be expected from present art scanning electron microscopy.

In another embodiment, which is schematically illustrated in Figs 5b and 5c, the shielding electrode 10 comprises a fine meshed conductive grid 11. A preferred mesh is for example 700 pitch per inch (275.59 per centimeter) with a total transmissivity T of around 50 % and a thickness of 10µm. Other values are also possible, for example a grid with only 200 pitch per inch (78,74 per centimeter) and values for T ranging from 30 % to 80 %. Also the thickness of the grid may vary from 1 - 30 microns.

The grid 11 is positioned about 50 µm above the sample surface 20 and is held at ground potential. The primary electron beam 1, having an energy between a few hundred volts and a few kilovolts, is passing through one of the free squares 15 of the grid, releasing secondary electrons off the sample surface. The shielding effect of the grid 11 is comparable to the embodiment of Fig. 5a, however, the operator's navigation is facilitated by the grid structure, as it shows a larger amount of surface 20 and not only the section below the opening 30. Further, the grid 11 allows a better access of process gases (not shown) to the sample surface 20. The latter is particularly important for sample surface 20 modification by charged particle beam induced chemical reactions and can be influenced by the transmissivity T of the grid 11.

Figs. 6a and 6b illustrate another important application of the present invention, wherein the electron beam is used to selectively deposit or remove material from the surface, for example for the repair of costly masks used in photolithography for the manufacture of semiconductor devices. The deposition is achieved by bringing precursor substances 91 into the vicinity of the surface, such as suitable organo-metallic compounds, which are selectively decomposed by the electron beam 1. It is apparent that the resolution of this technique will be affected, if the beam 1 is deviated or defocused due to charges accumulating on the surface of the sample.

In the embodiment of Fig. 6a, an additional gas supply 90 is provided above the aperture 30. The distance of the gas supply 90 from the aperture 30 and the size of the latter must be selected such that sufficient molecules or atoms 91 can reach the surface 20 through the aperture 30.

Fig. 6b discloses a further embodiment, wherein the shielding electrode 10 comprises a very small, preferably rectangular opening 30 in a thin membrane 12. The membrane surface is conductive and the membrane 12 is preferably fixed to a supporting structure 60 (e.g. a silicon wafer), as it is commonly used in transmission electron microscopy. The foil or membrane 12 is perforated (for example by electron beam lithography, focussed ion beam (FIB) or laser beam micro-machining), thus representing an aperture 30 of preferably 10 microns or less in size. The aperture opening shape can be adjusted in such a way as to optimize the primary beam scan field with maximum shielding efficiency. Structures of the type shown in Fig. 6b are very flat and can be brought into the closest vicinity of the sample surface, with distances of for example less than 20 microns. This type of embodiment offers highest precision primary beam positioning accuracy without touching the sample surface.

The embodiment of Fig. 6b is particularly suitable for the surface modification by SEM electron beam induced chemical reactions as described above. Here the short distance between the shielding electrode 10 and the surface 20 in combination with a very small opening 30 allows aspect ratios (sample-electrode distance to opening size) of about unity. One or more process gas inlets 90 can be integrated into the supporting structure 60, for example by standard MEMS-technology. A gas inlet below the shielding electrode has the further advantage that the gas pressure at the sample surface 20 is higher without deteriorating the overall pressure of the vacuum in the measurement chamber above the shielding electrode 10. The embodiment of Fig. 6b allows an electron beam induced chemical surface modification with a precision in the range of a few nanometers.

In a further embodiment (not shown) the opening in the shielding electrode is a lengthy slit, wherein one dimension of the opening is much larger than the other dimension, the smaller dimension being sufficiently small (e. g. smaller than 100 microns) to ensure proper functionality, the larger dimension being large enough to allow the full scan length for the beam. The smaller dimension has values as indicated above for the dimension d of the other embodiments. This alternative is especially valuable in electron beam raster scan writing tools, which are employed in the semiconductor process industry.

In another embodiment the electrode comprises multiple openings of any of the types described above. This is especially valuable for multi-beam exposure systems, as they are increasingly under development for increasing working speed (e.g. wafer inspection time, or mask writing time) in parallel beam systems.

In the described SEM-application the electrons have preferably a sufficient energy for a secondary electron coefficient of > 1. This leads to a positive charge on the sample surface, which can than be effectively shielded by the electrode 10. However, if the primary beam is a beam of electrons of such an energy that the secondary electron emission coefficient is less than unity, leading to negative charge build-up on the sample surface, an additional beam of photons or low energy electrons can be focused onto the same spot as the primary electron beam. This additional beam overcompensates the high negative charge caused by the primary beam, resulting in a low positive charge at the surface, so that the described invention can be applied.

## Claims

1. Apparatus for investigating and / or modifying a sample with charged particles, in particular a scanning electron microscope, comprising:
a. a beam (1, 2) of charged particles, wherein the beam (1, 2) of charged particles is scanned over a surface (20) of the sample;
b. a shielding element (10) having an opening (30) for the beam (1, 2) of charged particles to pass through;
c. wherein the opening (30) has a shape corresponding to the part of the surface (20) to be scanned, and wherein the shielding element is located a distance above the surface (20) of the sample so that the shielding element (10) does not contact the surface (20) of the sample and the distance is ≤ 100 µm to reduce the influence of charge accumulation effects at the surface on the beam (1, 2) of charged particles; and
d. wherein the shielding element (10) comprises a conductive grid (11) or a conductive membrane (12);
**characterised in that** the shielding element (10) is kept at a ground potential.

2. Apparatus according to claim 1, wherein the opening (30) has a diameter d, wherein d ≤ 100 µm, preferably ≤ 50 µm, and more preferably ≤ 10 µm.

3. Apparatus according to any of the preceding claims, wherein the distance between the shielding element (10) and the surface (20) of the sample is ≤ 50 µm and preferably ≤ 10 µm.

4. Apparatus according to any of the preceding claims, wherein the shielding element (10) has an outer dimension d' of ≤ 0.2 mm, preferably ≥ 2 mm, more preferably ≥ 5 mm and most preferably ≥ 10 mm and/or has a thickness of ≤ 100 µm, preferably 10-50 µm, more preferably ≤ 10 µm.

5. Apparatus according to any of the preceding claims, wherein the charged particles are electrons having an energy below 5 keV.

6. Apparatus according to any of the preceding claims comprising a plurality of openings (30) in one or more shielding elements (10) for a plurality of beams (1, 2) for investigating and / or modifying the sample.

7. Apparatus according to any of the preceding claims, wherein the shielding element (10) comprises apart from the one or more openings a continuous conducting area.

8. Apparatus according to any of the preceding claims, wherein the conductive grid (11) has a pitch of more than 200 per inch (78.74 per centimeter), preferably more or equal to 700 per inch (275.59 per centimeter), and / or a transmissivity T of 30 % ≤ T ≤ 80 %, and / or a thickness of 1 - 30 µm.

9. Method for investigating and / or modifying a sample using an apparatus according to any of the claims 1 - 8.

10. Method according to claim 9, wherein the apparatus is used for the repair of a mask as used in the semiconductor industry, in particular for the selective removal and / or deposition of material from or on the mask, respectively.

11. Method according to claim 9, wherein the apparatus is used for CD-SEM measurements.

## Patentansprüche

1. Vorrichtung zur Untersuchung und/oder Modifizierung von Proben mit Ladungsträgern, insbesondere ein Rasterelektronenmikroskop, die umfasst:
a. einen Ladungsträgerstrahl (1, 2), wobei der Ladungsträgerstrahl (1, 2) über einer Oberfläche (20) der Probe abgetastet wird;
b. ein Abschirmelement (10), das eine Öffnung (30) aufweist, durch die der Ladungsträgerstrahl (1, 2) verläuft;
c. wobei die Öffnung (30) eine Form aufweist, die dem Teil der abzutastenden Oberfläche (20) entspricht, und wobei das Abschirmelement in einer Distanz über der Oberfläche (20) der Probe angeordnet ist, so dass das Abschirmelement (10) nicht mit der Oberfläche (20) der Probe in Kontakt kommt, und die Distanz ≤ 100 µm ist, um den Einfluss von Ladungsakkumulationseffekten an der Oberfläche auf den Ladungsträgerstrahl (1, 2) zu verringern; und
d. wobei das Abschirmelement (10) ein leitendes Gitter (11) oder eine leitende Membran (12) umfasst;
**dadurch gekennzeichnet, dass**
das Abschirmelement (10) auf Erdpotential gehalten wird.

2. Vorrichtung nach Anspruch 1, wobei die Öffnung (30) einen Durchmesser d aufweist, wobei d ≤ 100 µm, vorzugsweise ≤ 50 µm und stärker bevorzugt ≤ 10 µm ist.

3. Vorrichtung nach einem der vorhergehenden Ansprüche, wobei die Distanz zwischen dem Abschirmelement (10) und der Oberfläche (20) der Probe ≤ 50 µm und vorzugsweise ≤ 10 µm ist.

4. Vorrichtung nach einem der vorhergehenden Ansprüche, wobei das Abschirmelement (10) eine Außenabmessung d' von ≥ 0,2 mm, vorzugsweise ≥ 2 mm, stärker bevorzugt ≥ 5 mm und am stärksten bevorzugt ≥ 10 mm aufweist und/oder eine Dicke von ≤ 100 µm, vorzugsweise 10 - 50 µm, stärker bevorzugt ≤ 10 µm aufweist.

5. Vorrichtung nach einem der vorhergehenden Ansprüche, wobei die Ladungsträger Elektronen sind, die eine Energie von weniger als 5 keV aufweisen.

6. Vorrichtung nach einem der vorhergehenden Ansprüche, die eine Vielzahl von Öffnungen (30) in einem oder mehreren Abschirmelementen (10) für eine Vielzahl von Ladungsträgerstrahlen (1, 2) zur Untersuchung und/oder Modifizierung der Probe umfasst.

7. Vorrichtung nach einem der vorhergehenden Ansprüche, wobei das Abschirmelement (10) außer der einen oder den mehreren Öffnungen einen durchgehenden leitenden Bereich umfasst.

8. Vorrichtung nach einem der vorhergehenden Ansprüche, wobei das leitende Gitter (11) eine Teilung von mehr als 200 pro Inch (78,74 pro Zentimeter), vorzugsweise mehr als oder gleich 700 pro Inch (275,59 pro Zentimeter) und/oder ein Durchlassvermögen T von 30 % ≤ T ≤ 80 % und/oder eine Dicke von 1 - 30 µm aufweist.

9. Verfahren zur Untersuchung und/oder Modifizierung einer Probe unter Verwendung einer Vorrichtung nach einem der Ansprüche 1 - 8.

10. Verfahren nach Anspruch 9, wobei die Vorrichtung für die Reparatur einer Maske verwendet wird, wie sie in der Halbleiterindustrie verwendet wird, insbesondere jeweils für das selektive Entfernen und/oder Abscheiden von Material von der oder auf die Maske.

11. Verfahren nach Anspruch 9, wobei die Vorrichtung für CD-SEM-Messungen verwendet wird.

## Revendications

1. Appareil destiné à inspecter et/ou modifier un échantillon avec des particules chargées, en particulier un microscope électronique à balayage, comprenant :
a. un faisceau (1, 2) de particules chargées, le faisceau (1, 2) de particules chargées étant balayé sur une surface (20) de l'échantillon ;
b. un élément de blindage (10) ayant une ouverture (30) pour que le faisceau (1, 2) de particules chargées passe à travers ;
c. dans lequel l'ouverture (30) a une forme correspondant à la partie de la surface (20) à balayer, et dans lequel l'élément de blindage est situé à une distance au-dessus de la surface (20) de l'échantillon telle que l'élément de blindage (10) ne touche pas la surface (20) de l'échantillon et la distance est ≤ 100 µm pour réduire l'influence des effets d'accumulation de charges à la surface sur le faisceau (1, 2) de particules chargées ; et
d. dans lequel l'élément de blindage (10) comprend une grille conductrice (11) ou une membrane conductrice (12) ;
**caractérisé en ce que** l'élément de blindage (10) est maintenu à un potentiel de terre.

2. Appareil selon la revendication 1, dans lequel l'ouverture (30) a un diamètre d, dans lequel d ≤ 100 µm, de préférence ≤ 50 µm, et mieux encore ≤ 10 µm.

3. Appareil selon l'une quelconque des revendications précédentes, dans lequel la distance entre l'élément de blindage (10) et la surface (20) de l'échantillon est ≤ 50 µm et de préférence ≤ 10 µm.

4. Appareil selon l'une quelconque des revendications précédentes, dans lequel l'élément de blindage (10) a une dimension extérieure d' s 0,2 mm, de préférence ≥ 2 mm, mieux encore ≥ 5 mm et idéalement ≥ 10 mm et/ou a une épaisseur ≤ 100 µm, de préférence de 10-50 µm, mieux encore ≤ 10 µm.

5. Appareil selon l'une quelconque des revendications précédentes, dans lequel les particules chargées sont des électrons ayant une énergie inférieure à 5 keV.

6. Appareil selon l'une quelconque des revendications précédentes comprenant une pluralité d'ouvertures (30) dans un ou plusieurs éléments de blindage (10) pour une pluralité de faisceaux (1, 2) pour inspecter et/ou modifier l'échantillon.

7. Appareil selon l'une quelconque des revendications précédentes, dans lequel l'élément de blindage (10) comprend à l'écart de la ou des ouvertures une zone conductrice continue.

8. Appareil selon l'une quelconque des revendications précédentes, dans lequel la grille conductrice (11) a un pas de plus de 200 par pouce (78,74 par centimètre), de préférence supérieur ou égal à 700 par pouce (275,59 par centimètre), et/ou un facteur de transmission T de 30 % ≤ T ≤ 80 %, et/ou une épaisseur de 1-30 µm.

9. Procédé d'inspection et/ou de modification d'un échantillon utilisant un appareil selon l'une quelconque des revendications 1 à 8.

10. Procédé selon la revendication 9, dans lequel l'appareil est utilisé pour la réparation d'un masque tel qu'employé dans l'industrie des semi-conducteurs, en particulier pour le retrait et/ou le dépôt sélectifs de matière depuis ou sur le masque, respectivement.

11. Procédé selon la revendication 9, dans lequel appareil est utilisé pour des mesures de CD-SEM.
